# EUROPEAN PATENT SPECIFICATION

(11) **EP 2 088 443 B1**
(45) Date of publication and mention of the grant of the patent: **03.08.2011**
(21) Application number: 08425075.2
(22) Date of filing: 08.02.2008
(51) Int. Cl.: G01R 31/319, G01R 1/073, G01R 1/067

(54) **Contact probe for a testing head having vertical probes with improved scrub movement**
Kontaktstift für einen Prüfkopf mit vertikalen Prüfnadeln mit verbesserter Schrubb-Bewegung
Sonde de contact pour une tête de test disposant de sondes verticales avec mouvement de frottement amélioré

(43) Date of publication of application: 12.08.2009
(73) Proprietor: Technoprobe S.p.A, 23870 Cernusco Lombardone (Lecco) (IT)
(72) Inventor: Crippa, Roberto, I-23870 Cernusco Lombardone (Lecco) (IT); Crippa, Guiseppe, I-23870 Cernusco Lombardone (Lecco) (IT); Lazzari, Stefano, I-23870 Cernusco Lombardone (Lecco) (IT)
(74) Representative: Zambardino, Umberto

(56) References cited:
- EP-A- 1 154 276
- WO-A-99/49329
- WO-A-2007/146186
- US-A1- 2005 258 844
- US-A1- 2008 001 612

## Description

### Field of application

The present invention refers to a testing head provided with vertical probes.

Furthermore, the invention refers to a testing head provided with vertical probes of the type comprising at least a first and a second plate-shaped support respectively provided with at least a guide hole for the accommodation of at least one contact probe having at least one end portion adapted to ensure mechanical and electrical contact with a corresponding contact pad of an electronic measuring device or a testing apparatus.

### Prior Art

As known, a testing head is a device adapted for electric connection of a plurality of contact pads of a microstructure with corresponding channels of a measuring machine, which performs its functionality test, in particular electric functionality, or general testing.

The test performed on integrated circuits serves in particular to detect and insulate faulty circuits already in the production step. Usually, the testing heads are, thus, used for the electric test of integrated circuits on wafers before cutting and mounting the same into a chip holding package.

A testing head basically comprises a plurality of moveable contact elements or contact probes constrained by at least a pair of plates or substantially plate-shaped guides and parallel to each other. Said guides are provided with special holes and arranged at a given distance from each other in such a manner to leave a free zone or air zone for the movement and possible deformation of the contact probes. The pair of guides comprises in particular an upper guide and a lower guide, both provided with guide holes within which the contact probes, which are usually made of special alloy wires with good electrical and mechanical properties, slide axially.

Proper connection between the measuring probes and the contact pads of the testing device is ensured by the pressure of the testing head on the device itself, the contact probes, which are moveable within the guide holes made in the upper and lower guides, being subjected in occasion of such pressing contact to a bending, inside the air zone between the two guides and a sliding within said guide holes. Testing heads of this type are commonly known as testing heads with vertical probes.

For instance, testing heads with vertical probes are described in the US Patent Applications published under No. US 2005/0258844 and No. US 2005/0001612 in the name of Kister as well as in the PCT Application published under No. WO 2007/146186 in the name of Microprobe, Inc..

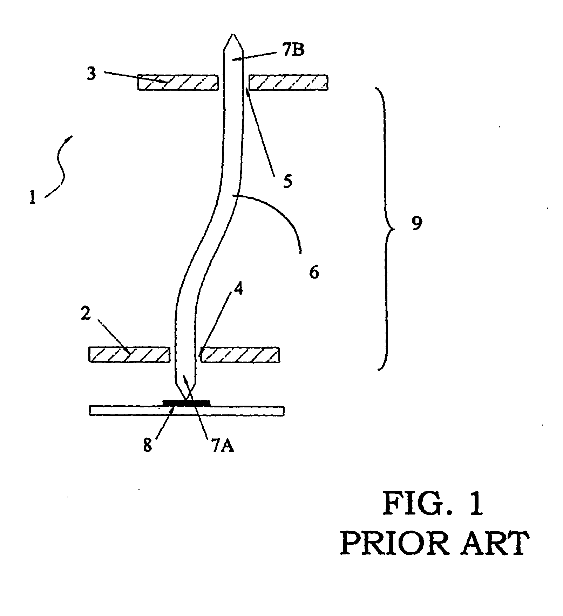

Basically, the testing heads with vertical probes have an air zone where a bending of the contact probes occurs, such bending being possibly facilitated by means of a suitable configuration of the probes themselves or of their guides, as schematically illustrated in figure 1, where, for illustration simplicity purposes, only one contact probe of the plurality of probes usually comprised in a testing head has been shown.

In particular, figure 1 schematically illustrates a testing head 1 comprising at least one lower guide 2 and one upper guide 3, both of them provided with guide holes 4 and 5 inside which at least one contact probe 6 slides.

The contact probe 6 is provided with at least one end portion 7A ending with a contact tip. In particular, the end portion 7A ends in abutment against a contact pad 8 of a device to be tested, performing the mechanical and electrical contact between said device and a testing apparatus (not shown) in which such testing head forms an end element.

The term "contact tip" is used in this case and hereinafter to indicate a zone or area of an end portion of a contact probe intended to come into contact with the device to be tested or the testing apparatus, said contact zone or area not necessarily being pointed.

In some cases, the contact probes are constrained to the head itself at the upper guide in a fixed manner: commonly known as fixed probes testing heads.

However, more commonly used are testing heads with probes not fixed in a permanent manner, but fastened interfaced with a so-called board, possibly through a micro-contact structure, called "space transformer": commonly known as non-fixed probes testing heads.

In this case, as illustrated in figure 1, the contact probe 6 has a further end portion 7B with the contact tip directed towards a plurality of contact pads of the space transformer, not illustrated in that it is of the conventional type. Proper electrical contact between probes and the space transformer is ensured in a manner analogous to the contact with the device to be tested thorough the pressure of the probes against the contact pads of the space transformer.

The lower 2 and the upper 3 guides are suitably spaced by an air zone 9which allows the deformation of the contact probes 6. Lastly, the guide holes 4 and 5 are dimensioned in such a manner to allow a sliding of the contact probe 6 inside them.

The shape of deformation to which the probes are subjected to and the force required to generate such deformation depend on various factors, such as the physical characteristics of the alloy composing the probes and the offset value between the guide holes in the upper guide and the corresponding guide holes in the lower guide.

Proper operation of a testing head is basically linked to two parameters: the vertical movement, or overtravel, of the contact probes and the horizontal movement, or scrub, of the contact tips of such contact probes. In particular, it is extremely important to make sure that the scrub of the contact tips allows to "clean" the contact pad on the surface, improving the contact performed by the testing head.

All these characteristics are to be assessed and regulated in the manufacturing step of the testing head, proper electric connection between the probes and the device to be tested always requiring to be guaranteed. In case of a testing head 1 made according to the so-called "shifted plates" technology, the contact probes 6 are made straight, with a circular transverse section constant along the entire length and usually pointed at the ends to form contact tips 7A and 7B, as shown in figure 1.

In order to obtain proper operation of the contact probes 6, the lower 2 and the upper 3 guides are suitably shifted between them to allow a preferred bending of the contact probes 6 in the same direction.

Assembly of the contact probes 6 in testing heads made according to the shifted plate technology is thus very easy and quick to perform. In particular, all that is required is to align their lower 2 and upper 3 guides between them in such a manner to align the corresponding guide holes 4 and 5 also, then fit the contact probes 6 into the guide holes 4 and 5, shift the guides between them by an adequate value thus locking them into position.

Though the testing heads of the abovementioned type are adequate and substantially meet the objective, in this technical sector there is always the urge to improve the scrub action of the contact tips on the contact pads in particular of the device to be tested in such a manner to ensure better electrical contact between the probes of the testing head and the respective contact pads and, hence, a better operation of the testing head.

Thus, the technical problem on which the present invention is based is that of finding a testing head for microstructures comprising probes configured in a manner to ensure an improved electrical contact with the contact pads of the device to be tested, hence meeting the abovementioned need.

### Summary of the invention

Such technical problem is overcome by means of a testing head with vertical probes comprising at least a first and a second plate-shaped supports provided with at least one guide hole for the accommodation of at least one contact probe, said at least one contact probe having an extended body of a preset longitudinal axis comprising an intermediate portion intended to be in peripheral contact with a guide wall of the guide hole of at least one support and an end portion adapted to ensure the mechanical and electrical contact with a corresponding contact pad of an electronic device to be tested, the testing head being characterised in that the intermediate portion of said at least one contact probe comprises a substantially cam-shaped section whose profile engages with said guide wall in such a manner to cause a transverse and/or rotational scrub movement to scrub said contact pad by means of said end portion, due to a vertical movement of said at least one contact probe triggered by a force operating on it in an axial direction.

Furthermore, such technical problem is overcome by a contact probe of a testing head with vertical probes, the contact probe having an extended body of a preset longitudinal axis comprising an intermediate portion intended to be in peripheral contact with a guide wall of the guide hole of at least one support of said testing head and an end portion adapted to ensure mechanical and electrical contact with a corresponding contact pad of an electronic device to be tested, characterised in that the intermediate portion of said at least one contact probe comprises a substantially cam-shaped section whose profile engages with said guide wall in such a manner to cause a transverse and/or rotational scrub movement to scrub said contact pad by means of said end portion, due to a vertical movement of the contact probe triggered by a force operating on it in an axial direction.

According to the present invention, the substantially cam-shaped section can be made in any manner such to obtain an axially variable transverse section such to trigger a transverse and/or rotational scrub movement to scrub the contact pad of a device to be tested by means of the end portion of the contact probe, due to a vertical movement of said contact probe triggered by a force operating on it in an axial direction.

Such axial force is applied by pressing the contact probe of the invention from below in such a manner to provide a pressing contact between the end portion and the respective contact pad of a device to be tested.

Preferably, said extended body is prism-shaped, in particular a prism shape with a rectangular base, with a side intended be in peripheral contact with the guide wall of the respective guide hole of the support of the testing head.

Preferably, said end portion ends with a contact tip intended for electrical and mechanical contact with a corresponding contact pad of a device to be tested. Such contact tip can be central, that is aligned with the longitudinal axis of the body of the probe, or eccentric that is offset with respect to the longitudinal axis of the body of the probe.

According to a preferred embodiment of the invention, the substantially cam-shaped section comprises a ramp provided with a transverse section constantly rising towards said end portion. Preferably, such ramp is provided on said side intended to be in peripheral contact with said guide wall of the respective support of the testing head.

In such manner, the action of an external compression force operating on the contact probe, to provide mechanical and electrical contact between the end portion of the probe and the contact pad of a device to be tested, leads to a relative vertical movement between said intermediate portion and said guide wall which also includes said cam-shaped section at least partially. This implies, due to the cam profile guaranteed in this case by the ramp, also a horizontal movement which advantageously generates an adequate horizontal scrub of the contact pad of the device to be tested by means of the contact tip of the probe.

The substantially cam-shaped section can also be made with a "torsion solid" outline in such a manner that said section of the intermediate portion of the probe has a substantially helical extension.

Thus, according to a preferred embodiment of the invention, said substantially cam-shaped section can be made with a torsion solid profile with a preset torsion angle and comprising a ramp or, in other words, with a substantially helical extension profile with a preset angle and comprising a helical ramp.

In such manner, the scrubbing movement on the contact pad of the device to be tested by means of the contact tip occurs advantageously according to a rotation-translation movement.

According to another embodiment of the invention, said substantially cam-shaped section can be made with a torsion solid profile having variable torsion angles and comprising a ramp or, in other words, a substantially helical extension profile with variable angles and comprising a helical ramp.

Preferably, such variable angles rise towards the end portion of the contact probe.

In such manner, it is possible to advantageously heighten the rotation component of the rotation-translation movement of the scrub applied by the contact tip on the contact pad of the device to be tested.

Preferably, the helical ramp (with constant or variable angle) has a transverse section rising towards the end portion of the probe.

According to a further embodiment of the invention, the substantially cam-shaped section is not provided with a ramp and it is made with a simple torsion solid profile with a constant angle or variable angles, or, in other words, with a substantially helical extension profile with a constant angle or variable angles.

Characteristics and advantages of the contact probe and the testing head according to the invention shall be clear from the description, provided hereinafter, of some preferred embodiments provided for indicative but non-limiting purposes with reference to the attached drawings.

### Brief description of the drawings

In such drawings:
Figure 1 schematically shows a testing head made according to the known art;
Figure 2 schematically shows a testing head according to the invention comprising a plurality of contact probes, wherein, however, for simplification reasons, only one contact probe is shown;
Figure 3 schematically shows a portion of a contact probe according to the invention, said probe being shown in an idle condition;
Figure 4 schematically shows a perspective view of the probe of figure 3 in an operating condition;
Figures 5-7 show respective cross-sections of the contact probe of figure 3 according to lines A-A, B-B and C-C;
Figure 8 shows a schematic perspective view of a contact probe according to another embodiment of the invention, said probe being shown in an operating condition;
Figures 9-11 show respective cross-sections of the contact probe of figure 8 according to lines A-A, B-B and C-C;
Figure 12 shows a schematic perspective view of a contact probe according to a further embodiment of the invention, said probe being shown in an operating condition;
Figures 13-15 show respective cross-sections of the contact probe of figure 12 according to lines A-A, B-B and C-C;

### Detailed description

Figure 1 shows a testing head made according to the known art and already described previously.

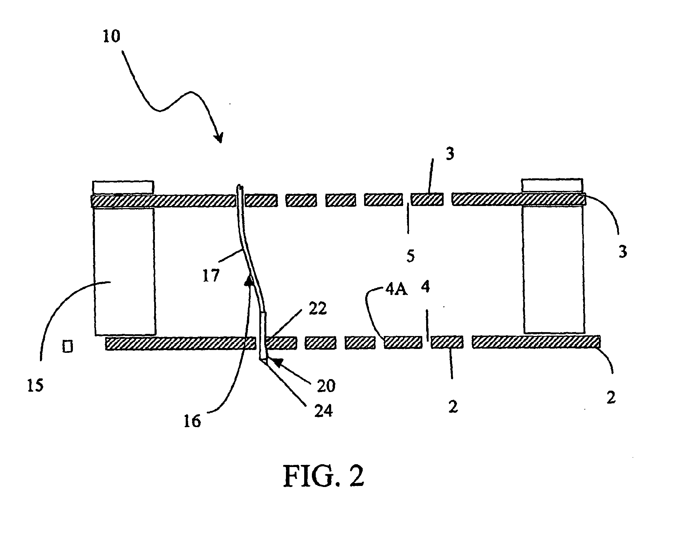

With reference to figure 2, a testing head made according to the invention is indicated in its entirety by 10. The testing head 10 is of the non-fixed probe type and it comprises a lower guide 2 and an upper guide 3 kept distant from each other by means of a spacer 15. Both the lower 2 and the upper 3 guides are provided with respective guide holes 4 and 5 inside which a plurality of contact probes 16 slide.

The contact probes 16 present in the testing head 10 are made of metallic conductor material, for example made of a metal alloy, and they can be made up of a single material or be provided with layers of different material depending on the specific requirements.

The contact probes 16 are extended vertically and have a curved or polygonal transverse section. Under use, the contact probes 16 are subjected to bendings and/or deformations as indicated previously regarding the prior art.

In particular, each contact probe has an extended body comprising an intermediate or central portion 17 and two oppositely positioned end portions 20 intended to be used in pressing abutment against a contact pad of a device to be tested and a contact pad of a testing device (for example a space transformer) respectively. For simplicity, figure 2 illustrates only one end portion 20 intended for mechanical and electrical contact with a contact pad of a device to be tested.

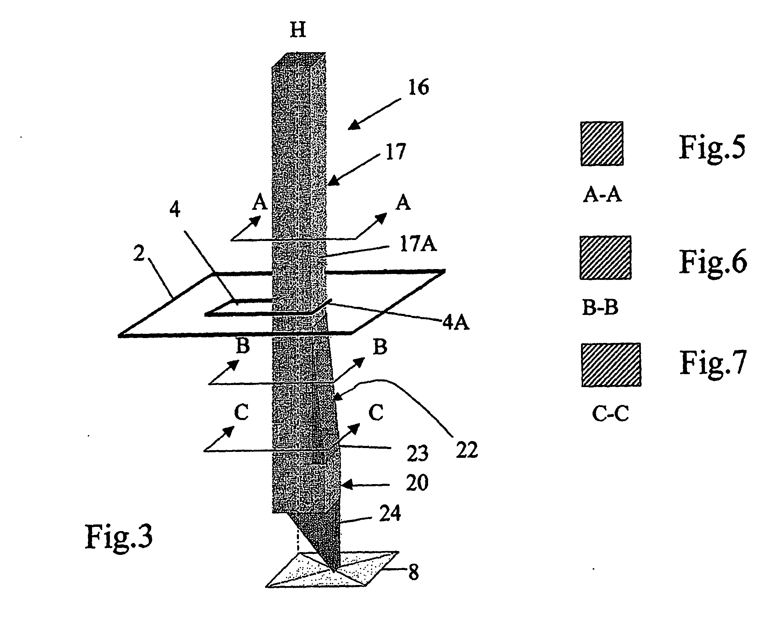

Referring now to figures 3-7, shown is a more detailed contact probe 16 according to the invention employed in the testing head 10, the contact probe 16 being capable of performing a mechanical and electrical contact with a scrubbing action on a contact pad 8 of a device to be tested. The contact probe 16 is prism-shaped extending in the longitudinal axis H direction. More in particular, the body of the probe 16 comprises an intermediate portion, generally indicated with 17, in peripheral contact, at one of its sides 17A, with a guide wall 4A of a guide hole 4 of a lower support 2 being part of a testing head 10, and an end portion 20 integrally joined to the intermediate portion 17 and ending in contact tip 24, for the mechanical and electrical contact with the contact pad 8 of the device to be tested.

In the present embodiment, such contact tip 24 is eccentric, that is offset with respect to the longitudinal axis H of the probe 16.

According to the present invention, the intermediate portion 17 comprises a section 22 provided with a substantially cam-shaped profile ending at the beginning of said end portion 20. In the present embodiment, such cam-shaped profile is made up of a ramp 23 formed on the side 17A of the intermediate portion 17 in peripheral contact with the wall 4A of the guide hole 4 and being provided with a slanted plane with a transverse section constantly rising towards the end portion 20.

Therefore, the section 22 of the intermediate portion 17 has an axially variable transverse section and in particular an area constantly rising towards the end portion 20, as observable in figures 5-7. In particular, such figures show how different axial levels correspond to transverse sections with a different area in the cam-shaped section 22, precisely rising moving towards the end portion 20, though still being made up of rectangles.

In the idle condition, shown in figure 3, the contact probe 16 just touches the relative contact pad 8 with the contact tip 24 (or it is spaced from it thereof) and the intermediate portion 17 is in peripheral contact with the wall 4A of the guide hole 4 in an area not included in the section 22 provided with a ramp 23 (but it could also be in contact in the area included in the section 22).

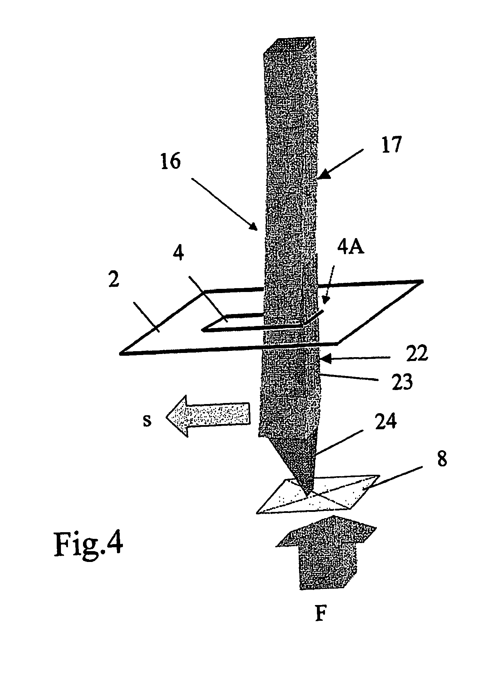

When passing from the idle condition to the measuring operating condition (figure 4), the contact probe is compressed from below (through a compression force F) thus providing a pressing contact between the end portion 20 shown in the figure (by means of the respective tip 24) and the contact pad 8 of the device to be tested and also between the oppositely positioned end portion (not shown) and a respective contact pad of the testing device (the oppositely positioned end portion being possibly constrained against the testing device). Such compression force causes a vertical movement (overtravel) of the contact probe 16 regarding the substantially cam-shaped section 22 whose profile engages, wholly or partially, with said guide wall 4A. This implies, due to the variable section guaranteed in this case by the ramp 23, also a horizontal movement s, at least of the end portion 20 (at a degree proportional to the overtravel triggered by the compression force applied onto the probe in the longitudinal axis H direction) which advantageously generates a suitable horizontal scrub of the contact pad 8 of the device to be tested by means of the contact tip 24).

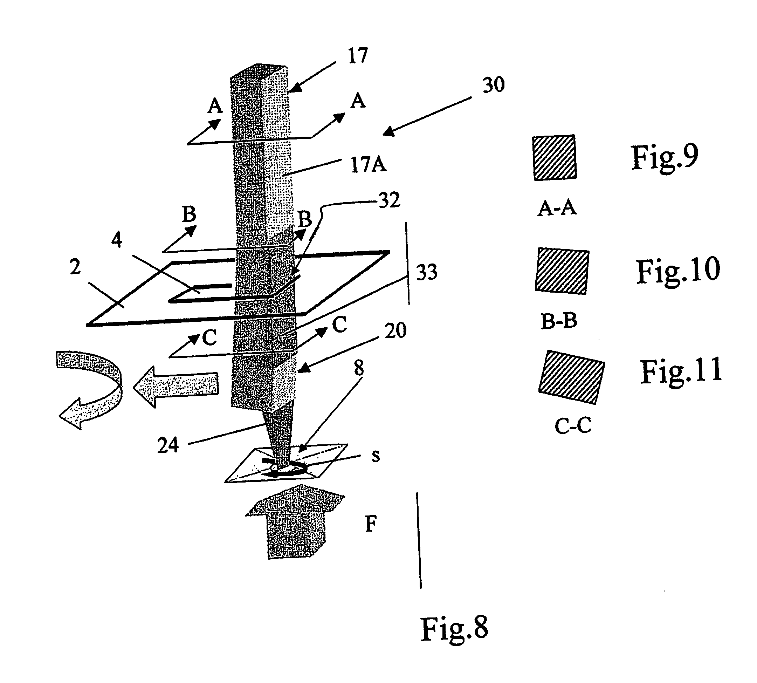

Referring now to figures 8-11, shown is a contact probe according to another embodiment of the invention, in an operating condition in the testing head 10, said contact probe being generally indicated with 30.

The elements of the contact probe 30 structurally and/or functionally equivalent to corresponding elements of the contact probe 16 described above shall bear the same reference numbers and for simplicity reasons shall not be described further unless required for the comprehension of the present invention.

The contact probe 30 has a prism-shaped body extending in the longitudinal axis H direction. More in particular, the body of the probe 30 comprises an intermediate portion, generally indicated with 17 in peripheral contact, at one of its sides 17A, with a guide wall 4A of a guide hole 4 of a lower support 2 being part of a testing head 10, and an end portion 20 integrally joined to the intermediate portion 17 and ending in a contact tip 24, for the mechanical and electrical contact with the contact pad 8 of the device to be tested.

In the present embodiment, such contact tip 24 is eccentric, that is offset with respect to the longitudinal axis H of the probe 16.

In this embodiment of the invention, the intermediate portion 17 comprises a cam-shaped section 32 having a torsion solid profile with a preset torsion angle and comprising a ramp 33 or, in other words, a substantially helical extension profile with a preset angle and comprising a helical ramp 33.

More in particular, the helical ramp 33 is made on the section 32, at the side 17A of the intermediate portion in peripheral contact with the guide wall 4A, and it has a transverse section rising towards the end portion 20.

Therefore, the section 32 of the intermediate portion 17 has an axially variable transverse section and in particular an area constantly rising towards the end portion 20, as observable in figures 9-11.

In such manner, the scrubbing movement s on the contact pad 8 of the device to be tested by means of the contact tip 24, due to the vertical movement of the probe 30 triggered by the compression force F operating on the probe 30 from below (in the longitudinal axis H direction), occurs advantageously according to a rotation-translation movement.

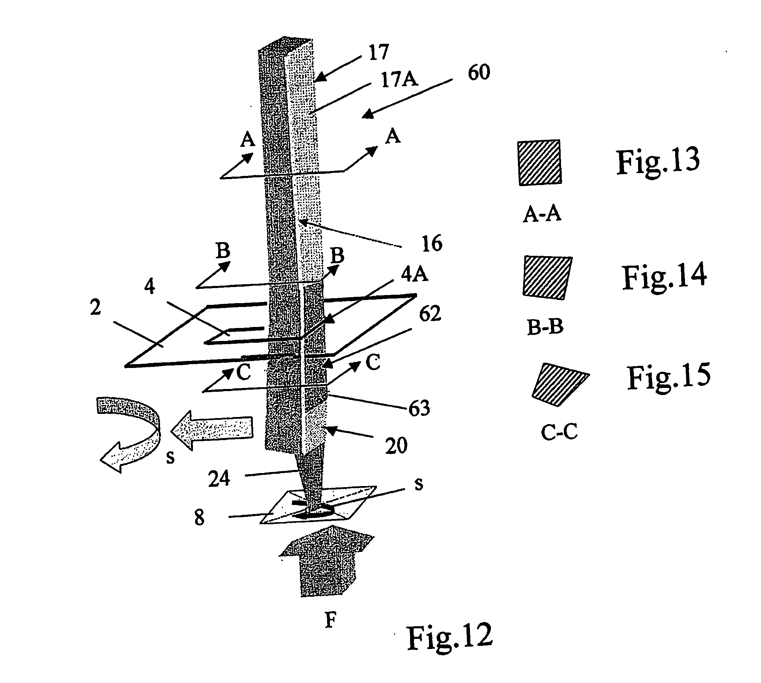

Referring now to figures 12-15, shown is a contact probe according to a further embodiment of the invention, in an operating condition in the testing head 10, said probe being generally indicated with 60.

The elements of the contact probe 60 structurally and/or functionally equivalent to the corresponding elements of the contact probe 30 described above shall bear the same reference numbers and for simplicity reasons shall not be described further unless required for the comprehension of the present invention.

The probe 60 is structurally and functionally equivalent to the probe 30 described above but, in this embodiment, the intermediate portion 17 comprises a substantially cam-shaped section 62 having a torsion solid profile with preset variable angles and comprising a ramp 63 or, in other words, a substantially helical extension profile with variable angles and comprising a helical ramp 63.

More in particular, the helical ramp 63 is made on the section 62, at the side 17A of the intermediate portion in peripheral contact with the guide wall 4A, and it has a transverse section rising towards the end portion 20.

Preferably, said variable angles rise towards the end portion 20 of the probe 62.

Therefore, the section 62 of the intermediate portion 17 has an axially variable transverse section and in particular an area constantly rising towards the end portion 20, as observable in figures 13-15.

In such manner, it is possible to advantageously heighten the rotation component of the rotation-translation scrub movement s applied by means of the contact tip 24 on the contact pad of the device to be tested.

According to a further embodiment of the invention, the probe 30 of figures 8-11 and the probe 60 of figures 12-15 can also be made without their respective helical ramps 33 and 63, simply with a torsion solid profile with a constant angle or variable angles, or, in other words, with a substantially helical extension profile with a constant angle or variable angles.

In such manner, it is possible to apply on the contact pad 8 of the device to be tested a scrub movement of the exclusively rotational type by means of the contact tip 24.

The main advantage of the contact probe according to the invention lies in its high efficacy to scrub a contact pad of a device to be tested hence allowing to improve the electric contact between the probe of the testing head and the respective contact pads and consequently enhancing the operation of the testing head. All this advantageously occurs according to the invention without causing any noticeable damage on the contact pads and thus without jeopardising the functionality of the device to be tested.

Another advantage of the invention lies in the fact that the contact probe can me made in a simple manner at a low cost and it can be advantageously fixed onto novel or already existing testing heads.

## Claims

1. Contact probe (16;30;60) for a testing head (10) with vertical probes, the contact probe (16;30;60) having an extended body of a preset longitudinal axis (H) comprising an intermediate portion (17) intended to be in peripheral contact with a guide wall (4A) of the guide hole (4) of at least one support (2) of said testing head (10) and an end portion (20) adapted to ensure the mechanical and electrical contact with a corresponding contact pad (8) of an electronic device to be tested, said contact probe being **characterised in that** said intermediate portion (17) comprises a substantially cam-shaped section (22;32;62) whose profile engages with said guide wall (4A) in such a manner to cause a transverse and/or rotational scrub movement (s) to scrub said contact pad (8) by means of said end portion (20), as a consequence of a vertical movement of the contact probe triggered by a force operating on it in an axial direction .

2. Contact probe (16) according to claim 1, **characterised in that** said substantially cam-shaped section (22) comprises a ramp (23) having a transverse section constantly rising towards end portion (20).

3. Contact probe (30) according to claim 1, **characterised in that** said substantially cam-shaped section (32) has torsion solid profile with a preset torsion angle.

4. Contact probe (60) according to claim 1, **characterised in that** said substantially cam-shaped section (62) has torsion solid profile with variable torsion angles.

5. Contact probe (60) according to claim 4, **characterised in that** said variable torsion angles rise towards said end portion (20).

6. Contact probe (30;60) according to any of claims 3-5, **characterised in that** said substantially cam-shaped section (32;62) having a torsion solid profile further comprises a helical ramp having a transverse section constantly rising towards said end portion (20).

7. Contact probe (16;30;60) according to any of the preceding claims **characterised in that** said extended body is substantially prism-shaped with one side (17A) intended to be in peripheral contact with said guide wall (4A) of the guide hole (4) of the support (2) of said testing head (10).

8. Contact probe (16;30;60) according to claim 7, **characterised in that** said ramp (23;33;63) is provided on said side (17A) of the extended body in peripheral contact with said guide wall (4A).

9. Contact probe (16;30;60) according to any of the preceding claims, **characterised in that** said substantially cam-shaped section (22;32;62) ends at said end portion (20).

10. Contact probe (16;30;60) according to one of the preceding claims, **characterised in that** said end portion (20) ends with a contact tip (24) intended for electrical and mechanical contact with said contact pad (8) of the electronic device to be tested.

11. Contact probe (16;30;60) according to claim 10, **characterised in that** said contact tip (24) is offset with respect to the longitudinal axis (H) of the body of the probe.

12. Testing head (10) with vertical probes of the type comprising at least a first and a second plate-shaped supports (2,3) provided with at least one guide hole (4,5) for the accommodation of at least one contact probe (16;30;60), said contact probe (16;30;60) being realised according to any one of claims 1-11.

## Patentansprüche

1. Kontaktstift (16; 30; 60) für einen Prüfkopf (10) mit vertikalen Prüfnadeln, wobei der Kontaktstift (16; 30; 60) einen entlang einer vorgegebenen Längsachse (H) sich erstreckenden Körper, welcher einen Zwischenteil (17) umfasst, welcher vorgesehen ist, um in umfangsseitigem Kontakt mit einer Führungswand (4A) des Führungslochs (4) wenigstens eines Trägers (2) des Prüfkopfes (10) zu stehen, und einen Endteil (20) aufweist, welcher geeignet ist, den mechanischen und elektrischen Kontakt mit einem entsprechendem Kontaktgebiet (8) einer zu prüfenden elektronischen Einrichtung sicherzustellen,
**dadurch gekennzeichnet, dass**
der Zwischenteil (17) einen im Wesentlichen kurvenförmigen Abschnitt (22; 32; 62) umfasst, dessen Profil mit der Führungswand (4A) derart ineinander greift, so dass eine quer verlaufende und/oder rotierende Schrubbbewegung (s) erzeugt wird, um das Kontaktgebiet (8) mittels des Endteils (20) als eine Folge einer vertikalen Bewegung der Prüfnadel, welche durch eine auf sie in axialer Richtung wirkende Kraft bedingt ist, zu schrubben.

2. Kontaktstift (16).nach Anspruch 1,
**dadurch gekennzeichnet, dass**
der im Wesentlichen kurvenförmige Abschnitt (22) eine Schräge (23) umfasst, welche einen Querschnitt aufweist, welcher in Richtung des Endteils (20) konstant zunimmt

3. Kontaktstift (30) nach Anspruch 1,
**dadurch gekennzeichnet, dass**
der im Wesentlichen kurvenförmige Abschnitt (32) ein Torsionsvollprofil mit einem vorgegebenen Torsionswinkel hat.

4. Kontaktstift (60) nach Anspruch 1,
**dadurch gekennzeichnet, dass**
der im Wesentlichen kurvenförmige Abschnitt (62) ein Torsionsvollprofii mit variablen Torsionswinkel hat.

5. Kontaktstift (60) nach Anspruch 4,
**dadurch gekennzeichnet, dass**
die variablen Torsionswinkel in Richtung des Endteils (20) zunehmen.

6. Kontaktstift (30; 60) nach einem der Ansprüche 3-5,
**dadurch gekennzeichnet, dass**
der im Wesentlichen kurvenförmige Abschnitt (32; 62) ein Torsionsvollprofil aufweist und darüber hinaus eine helikale Schräge aufweist, welche einen Querschnitt hat, welcher in Richtung des Endteils (20) konstant zunimmt.

7. Kontaktstift (16; 30; 60) nach einem der vorangegangenen Ansprüche,
**dadurch gekennzeichnet, dass**
der sich erstreckende Körper im Wesentlichen prismenförmig ist, wobei eine Seite (17A) vorgesehen ist, um in umfangsseitigem Kontakt mit der Führungswand (4A) des Führungslochs (4) des Trägers (2) des Prüfkopfes (10) zu sein.

8. Kontaktstift (16; 30; 60) nach Anspruch 7,
**dadurch gekennzeichnet, dass**
die Schräge (23; 33; 63) an der Seite (17A) des sich erstreckenden Körpers in umfangsseitigem Kontakt mit der Führungswand (4A) bereitgestellt ist.

9. Kontaktstift (16; 30; 60) nach einem der vorhergehenden Ansprüche,
**dadurch gekennzeichnet, dass**
der im Wesentlichen kurvenförmige Abschnitt (22; 32; 62) am Endteil (20) endet.

10. Kontaktstift (16; 30; 60) nach einem der vorhergehenden Ansprüche,
**dadurch gekennzeichnet, dass**
der Endabschnitt (20) mit einer Kontaktspitze (24) endet, welche für elektrischen und mechanischen Kontakt mit dem Kontaktgebiet (8) einer zu prüfenden elektronischen Einrichtung vorgesehen ist.

11. Kontaktstift (16; 30; 60) nach Anspruch 10,
**dadurch gekennzeichnet, dass**
die Kontaktspitze (24) in Bezug auf die Längsachse (H) des Körpers der Prüfnadel versetzt ist.

12. Prüfkopf (10) mit vertikalen Prüfnadeln der Art, welcher zumindest einen ersten und einen zweiten plattenförmigen Träger (2, 3) umfasst, welcher zumindest ein Führungsloch (4, 5) für die Anordnung zumindest eines Kontaktstiftes (16; 30; 60) bereitstellt, wobei der Kontaktstift (16; 30; 60) nach einem der Anspruche 1 - 11 ausgebildet ist.

## Revendications

1. Sonde de contact (16 ; 30 ; 60) pour une tête de test (10) dotée de sondes verticales, la sonde de contact (16 ; 30 ; 60) ayant un corps étendu d'un axe longitudinal prédéfini (H) comprenant une partie intermédiaire (17) prévue pour être en contact périphérique avec une paroi de guidage (4A) du trou de guidage (4) d'au moins un support (2) de ladite tête de test (10) et une partie d'extrémité (20) adaptée pour garantir le contact mécanique et électrique avec un plot de connexion (8) correspondant d'un dispositif électronique à tester, ladite sonde de contact étant **caractérisée en ce que** ladite partie intermédiaire (17) comprend une section sensiblement en forme de came (22 ; 32 ; 62) dont le profil se met en prise avec ladite paroi de guidage (4A) afin de provoquer un mouvement de frottement transversal et/ou rotatif (s) pour frotter ledit plot de connexion (8) au moyen de ladite partie d'extrémité (20), suite à un mouvement vertical de la sonde de contact déclenchée par une force agissant sur cette dernière dans une direction axiale.

2. Sonde de contact (16) selon la revendication 1, **caractérisée en ce que** ladite section sensiblement en forme de came (22) comprend une rampe (23) ayant une section transversale remontant de manière constante vers la partie d'extrémité (20).

3. Sonde de contact (30) selon la revendication 1, **caractérisée en ce que** ladite section sensiblement en forme de came (32) a un profil solide de torsion avec un angle de torsion prédéfini.

4. Sonde de contact (60) selon la revendication 1, **caractérisée en ce que** ladite section sensiblement en forme de came (62) a un profil solide de torsion avec des angles de torsion variables.

5. Sonde de contact (60) selon la revendication 4, **caractérisée en ce que** lesdits angles de torsion variables remontent vers ladite partie d'extrémité (20).

6. Sonde de contact (30 ; 60) selon l'une quelconque des revendications 3 à 5,
**caractérisée en ce que** ladite section sensiblement en forme de came (32 ; 62) ayant un profil solide de torsion comprend en outre une rampe hélicoïdale ayant une section transversale remontant de manière constante vers ladite partie d'extrémité (20).

7. Sonde de contact (16 ; 30; 60) selon l'une quelconque des revendications précédentes, **caractérisée en ce que** ledit corps étendu est sensiblement en forme de prisme avec un côté (17A) prévu pour être en contact périphérique avec ladite paroi de guidage (4A) du trou de guidage (4) du support (2) de ladite tête de test (10).

8. Sonde de contact (16 ; 30 ; 60) selon la revendication 7, **caractérisée en ce que** ladite rampe (23 ; 33; 63) est prévue sur ledit côté (17A) du corps étendu en contact périphérique avec ladite paroi de guidage (4A).

9. Sonde de contact (16 ; 30 ; 60) selon l'une quelconque des revendications précédentes, **caractérisée en ce que** ladite section sensiblement en forme de came (22 ; 32 ; 62) se termine au niveau de ladite partie d'extrémité (20).

10. Sonde de contact (16; 30 ; 60) selon l'une quelconque des revendications précédentes, **caractérisée en ce que** ladite partie d'extrémité (20) se termine par une pointe de contact (24) prévue pour le contact électrique et mécanique avec ledit plot de connexion (8) du dispositif électronique à tester.

11. Sonde de contact (16 ; 30 ; 60) selon la revendication 10, **caractérisée en ce que** ladite pointe de contact (24) est décalée par rapport à l'axe longitudinal (H) du corps de la sonde.

12. Tête de test (10) dotée de sondes verticales du type comprenant au moins une premier et un deuxième support en forme de plaque (2, 3) prévus avec au moins un trou de guidage (4, 5) pour loger au moins une sonde de contact (16 ; 30 ; 60), ladite sonde de contact (16 ; 30 ; 60) étant réalisée selon l'une quelconque des revendications 1 à 11.
